# EUROPEAN PATENT SPECIFICATION

(11) **EP 1 677 514 B1**
(45) Date of publication and mention of the grant of the patent: **08.12.2010**
(21) Application number: 06000089.0
(22) Date of filing: 03.01.2006
(51) Int. Cl.: H04N 3/15, G03B 9/14

(54) **Imaging apparatus and imaging method**
Bildaufnahmevorrichtung und Bildaufnahmeverfahren
Dispositif et procédé d'imagerie

(30) Priority: 04.01.2005 JP 2005000212
(43) Date of publication of application: 05.07.2006
(73) Proprietor: Sony Corporation, Minato-ku Tokyo (JP)
(72) Inventor: Hayashi, Naoki, Minato-ku Tokyo (JP); Asato, Seishin, Minato-ku Tokyo (JP); Tanaka, Kenji, Minato-ku Tokyo (JP)
(74) Representative: Müller - Hoffmann & Partner

(56) References cited:
- EP-A- 1 416 713
- EP-A- 1 601 187
- GB-A- 2 134 349
- US-A- 4 161 000
- US-A- 4 743 108
- US-A1- 2003 206 235
- US-A1- 2004 212 723
- "Shutter Operations for CCD and CMOS Image Sensors" APPLICATION NOTE MTD/PS-0259, XX, XX, 23 October 2001 (2001-10-23), pages 1-5, XP002231864

## Description

### CROSS REFERENCES TO RELATED APPLICATIONS

The present invention contains subject matter related to Japanese Patent Application JP 2005-000212 filed in the Japanese Patent Office on January 04, 2005.

### BACKGROUND OF THE INVENTION

### 1. Field of the Invention

The present invention relates to imaging apparatuses and imaging methods using solid-state image sensors to capture images. More particularly, the present invention relates to an imaging apparatus and an imaging method using a solid-state image sensor, such as a complementary metal oxide semiconductor (CMOS) image sensor, which reads out a pixel signal by an XY address method, to capture an image.

### 2. Description of the Related Art

Imaging apparatuses, such as digital still cameras and digital video cameras, capable of using solid-state image sensors to capture images and storing the captured images as digital data have been in widespread use in recent years. Although charge coupled device (CCD) image sensors are most popular as the imaging devices used in such imaging apparatuses, CMOS image sensors have drawn attention as the number of pixels in the solid-state image sensors is further increased. The CMOS image sensors are characterized by being capable of random access of pixel signals and by readout at higher speed, at higher sensitivity, and with lower power consumption, compared with the CCD image sensors.

Many CMOS image sensors are provided with an electronic shutter function. However, since a rolling shutter (or also referred to as a focal plane shutter) in which many pixels that are two-dimensionally arranged are sequentially scanned for every pixel row to output signals is adopted as the electronic shutter in the CMOS imaging sensors, unlike the CCD image sensors, there is a problem in that the exposure periods of the rows are shifted from each other.

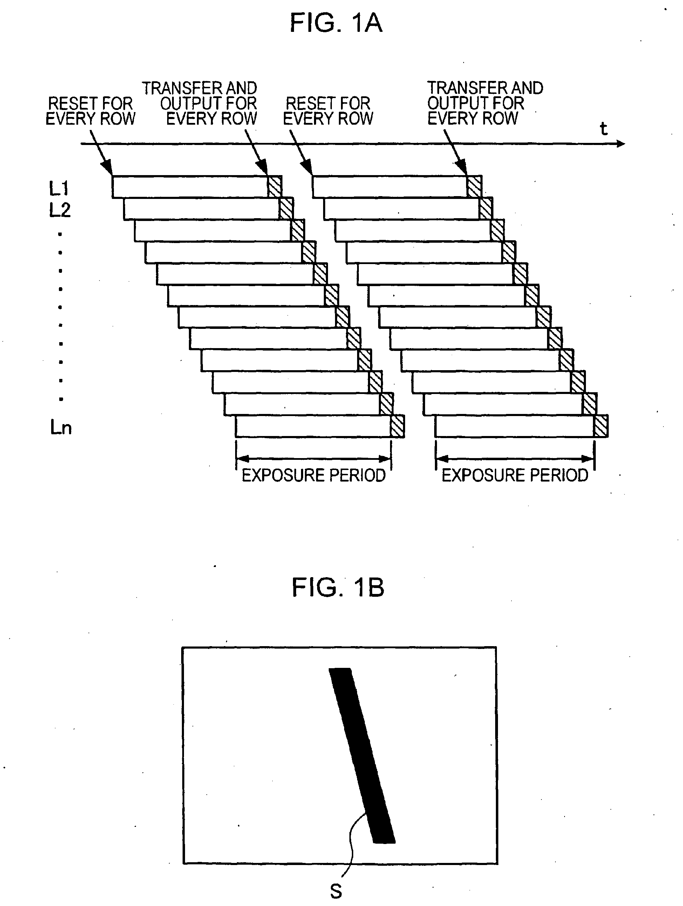

Fig. 1A shows exposure and charge transfer timings in a related art when the rolling shutter is used. Fig. 1B shows an image captured at these timings.

As shown in Fig. 1A, in a CMOS image sensor having pixels, for example, in n-number rows from L1 row to Ln row (n denotes an integer number that is larger than or equal to two), the exposure to a photodiode is started after each row is reset, accumulated electric charge is transferred after a predetermined exposure period, and a signal is output. Such an operation is sequentially performed with time delay from the L1 row to Ln row. Accordingly, for example, when an object S shaped in a vertical straight line moves in the horizontal direction, the object S is tilted in a still image of the object S, as shown in Fig. 1B.

In contrast, imaging devices in which the shutter is simultaneously triggered for all the rows to synchronize the exposure periods to all the rows have been developed. Such imaging devices simultaneously reset the photodiodes for all the rows at a certain time, transfer the charge in the photodiodes to a floating diffusion (FD) after a predetermined exposure period is elapsed, and sequentially output the signals in the FD for every row. Furthermore, there are imaging devices having drain transistors capable of directly discharging excessive charge in the photodiodes into drains through no FDs in order to simultaneously reset the signal charge in the photodiodes for all the rows (for example, refer to Japanese Unexamined Patent Application Publication No. 2001-238132.

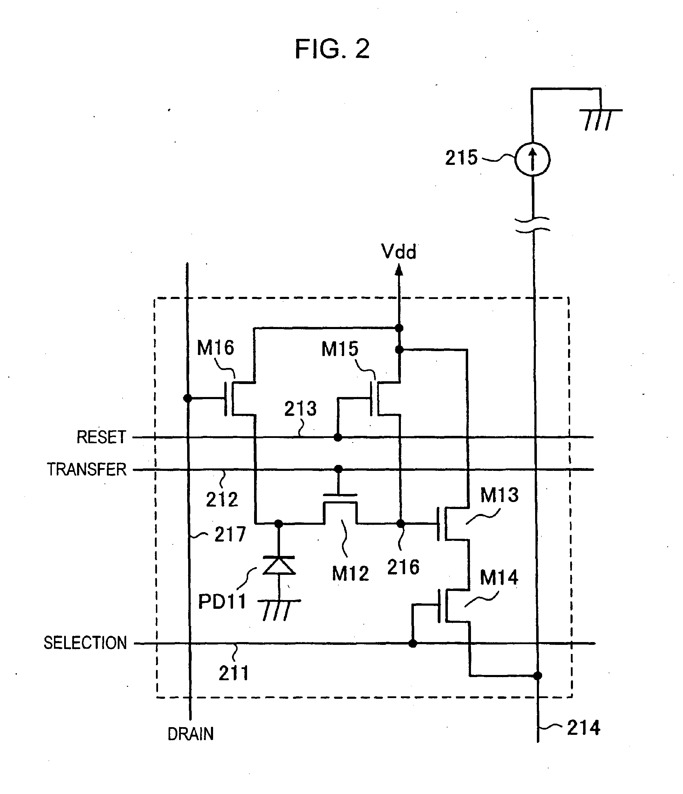

Fig. 2 shows an example of the configuration of each pixel circuit in a CMOS image sensor capable of simultaneously triggering the shutter for all the rows.

The pixel circuit in Fig. 2 includes a photodiode PD11, a transfer transistor M12, an amplification transistor M13, a selection transistor M14, a reset transistor M15, and a drain transistor M16. Each transistor is an n-channel MOS field effect transistor (MOSFET).

A row selection signal line 211, a transfer signal line 212, and a reset signal line 213 are connected to the gates of the selection transistor M14, the transfer transistor M12, and the reset transistor M15, respectively. These signal lines horizontally extend to simultaneously drive the pixels in the same row in order to control driving of the rolling shutter. A vertical signal line 214 is connected to the source of the selection transistor M14 and a drain signal line 217 is connected to the gate of the drain transistor M16. One end of the vertical signal line 214 is grounded via a constant current source 215. The drain signal line 217 is commonly provided for all the pixels.

The photodiode PD11 has electric charge, generated by photoelectric conversion, accumulated therein. The P semiconductor end of the photodiode PD11 is grounded and the N semiconductor end thereof is connected to the source of the transfer transistor M12. When the transfer transistor M12 is turned on, the charge in the photodiode PD11 is transferred to a floating diffusion (FD) 216. Since the FD 216 has a parasitic capacitance, the charge is accumulated in the FD 216.

A power supply voltage Vdd is applied to the drain of the amplification transistor M13, and the gate of the amplification transistor M13 is connected to the FD 216. The amplification transistor M13 converts a variation in voltage in the FD 216 into an electrical signal. The selection transistor M14 selects a pixel from which a signal is read out for every row. The drain of the selection transistor M14 is connected to the source of the amplification transistor M13, and the source thereof is connected to the vertical signal line 214. Since the amplification transistor M13 and the constant current source 215 form a source follower when the selection transistor M14 is turned on, a voltage associated with the voltage of the FD 216 is output to the vertical signal line 214.

The power supply voltage Vdd is applied to the drain of the reset transistor M15, and the source of the reset transistor M15 is connected to the FD 216. The reset transistor M15 resets the voltage of the FD 216 to the power supply voltage Vdd. The power supply voltage Vdd is applied to the drain of the drain transistor M16, and the source of the drain transistor M16 is connected to the source of the transfer transistor M12. The drain transistor M16 directly resets the charge accumulated in the photodiode PD11 with the power supply voltage Vdd.

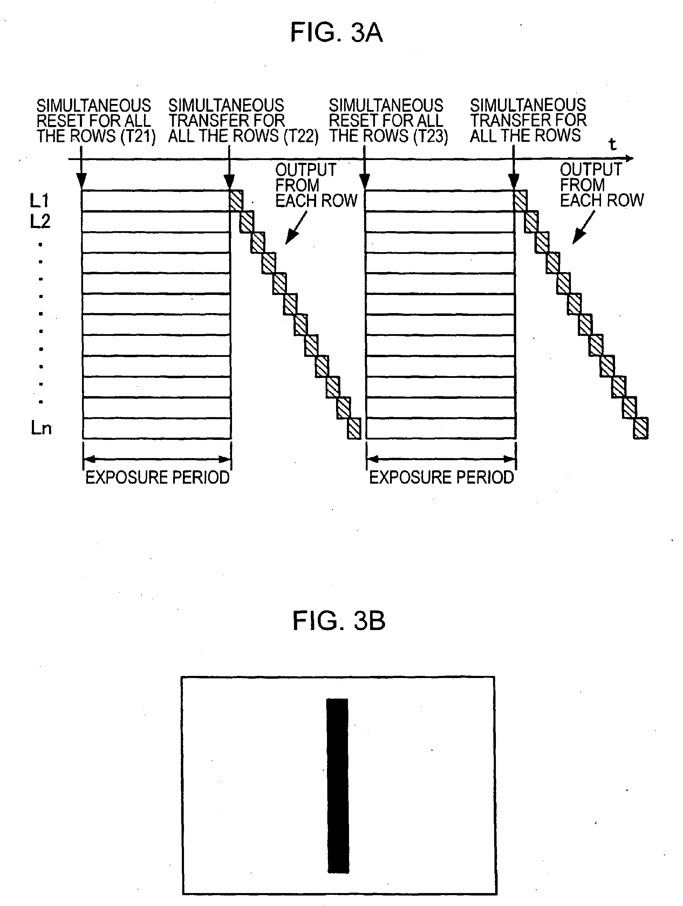

Fig. 3A shows exposure and charge transfer timings in the pixel circuit in Fig. 2. Fig. 3B shows an image captured at these timings.

The operation of the pixel circuit will now be described with reference to Fig. 3A.

First, the reset transistors M15 for all the pixels are turned on to set the FDs 216 for all the pixels to the power supply voltage Vdd. After the reset transistors M15 are turned off, the transfer transistors M12 for all the pixels are turned on to transfer a voltage in proportion to the accumulated charge from the photodiodes PD11 for all the pixels to the FDs 216. After the transfer transistors M12 are turned off, the drain transistors M16 for all the pixels are turned on to set the photodiodes PD11 for all the pixels to the power supply voltage Vdd.

Turning off the drain transistors M16 causes the photodiodes PD11 for all the pixels to simultaneously start accumulation of optical signals (a timing T21). When the transfer transistors M12 for all the pixels are turned on after a predetermined exposure period is elapsed, a voltage in proportion to the charge accumulated in the photodiodes PD11 is simultaneously transferred to the FDs 216 for all the rows (a timing T22). After the transfer transistors M12 are turned off, sequentially applying a high voltage to the row selection signal lines 211; that is, sequentially applying a high voltage to the row selection signal line 211 for the first row, to the row selection signal line 211 for the second row, and so on, to sequentially turn on the selection transistors M14 for the rows causes the optical signals to be read out. After the voltage of the FD 216, corresponding to the photodiode PD11, is output to the vertical signal line 214, the reset transistor M15 is turned on to output a voltage corresponding to the reset voltage of the FD 216 to the vertical signal line 214. The difference between the voltage of the FD 216, corresponding to the photodiode PD11, and the voltage corresponding to the reset voltage of the FD 216 become a signal voltage.

After the signal transfer for all the pixels is completed, the reset transistors M15 for all the pixels are turned on again to reset the FDs 216. After the reset transistors M15 are turned off, the transfer transistors M12 are turned on to discharge the accumulated charge into the FDs 216. After the transfer transistors M12 are turned off, the drain transistors M16 are turned on to set the voltage of the photodiodes PD11 to the power supply voltage Vdd and to directly discharge the excessive voltage in the photodiodes PD11 into the drains of the drain transistors M16. After the drain transistors M16 are turned off, the accumulation of the optical signals in the photodiodes PD11 is started again (a timing T23).

As described above, after the drain transistors M16 are turned on and off to simultaneously reset the photodiodes PD11 for all the rows and to start the exposure, the transfer transistors M12 are turned on to simultaneously transfer the accumulated charge to the FDs 216 for all the rows, so that the exposure periods for all the pixels are synchronized with each other. Hence, for example, when an object S shaped in a vertical straight line moves in the horizontal direction, the object S is not tilted but is upright in a still image of the object S, as shown in Fig. 3B.

Furthermore, imaging apparatuses in which both the channel voltage when the drain transistor M16 is turned on and the channel voltage when the transfer transistor M12 is turned on are set to a voltage higher than the voltage when the photodiode PD11 is completely emptied to relieve the restriction on the exposure period and ensure a sufficient exposure period in order to improve the quality of an output image have been developed (for example, Japanese Unexamined Patent Application Publication No. 2004-140149).

"Shutter operations for CCD and CMOS image sensors" APPLICATION NOTE MTD/PS-0259, XX, XX, October 23, 2001, pages 1 to 5, XP002231864 describes electronic shutter mechanisms such as CCD image sensor with electronic shutter, CMOS image sensor with a convention rolling shutter and CMOS image sensor with a Kodak patented global shutter.

EP 1 416 713 A1 describes an electronic imaging system with an image sensor reset synchronized to a mechanical shutter, wherein a shutter curtain which moves in a predetermined direction and with a predetermined speed to block light from reaching the image sensor is described.

US 2004/0212723 A1 describes an image pickup apparatus which comprises a CMOS image sensor, a lens module with mechanical shutter and a timing control means, as well as an method for operating this image pickup apparatus.

US 2003/0206235 A1 describes a MOS-type solid-state image pickup device included in a digital camera for obtaining a still picture undergone backlight correction without any blur even if a shooting object is moving at a high speed, and a digital camera using the device.

US 4,161,000 describes a high speed television camera control system wherein a conventional television camera is provided with a motor-driven rotating mechanical shutter assembly having a pair of adjustable, opposing shutter openings, and control circuitry for synchronizing the operation of the shutter assembly with the scanning of the camera's pickup tube to limit image movement on the pickup tube during a field scan in order to permit high clarity picture reproduction of scene objects moving rapidly across the camera's field of view.

### SUMMARY OF THE INVENTION

However, the CMOS image sensor capable of simultaneously triggering the shutter for all the rows, described above with reference to Fig. 2, has a problem in that light filters into the FDs 216 after the signal voltage is simultaneously transferred to the FDs 216 for all the rows before the signal voltage is sequentially output for every row to degrade the quality of the capture image because the rows differ in the amount of the filtering light from each other.

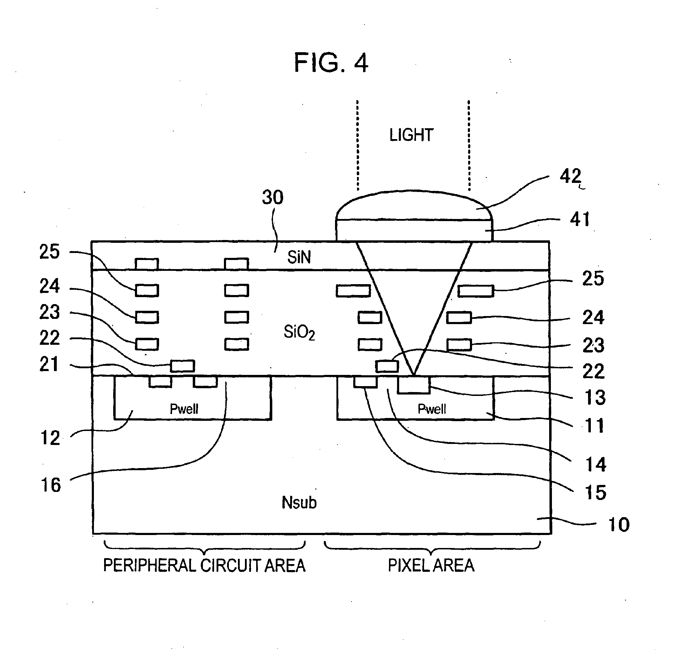

Fig. 4 is a cross-sectional view showing an example of the structure of an area near to a photodiode in a CMOS image sensor in a related art. The above problem will now be described in detail with reference to Fig. 4.

The CMOS image sensor in Fig. 4 has P well areas 11 and 12, serving as device forming areas, formed in an upper area of a semiconductor substrate (N-type silicon substrate) 10. A photodiode 13 and various gate devices are formed in the P well areas 11 and 12. In the example in Fig. 4, the photodiode 13, a transfer gate (MOS transistor) 14, and an FD 15 are formed in the P well area 11, and a MOS transistor 16 in a peripheral circuit area is formed in the P well area 12.

Polysilicon transfer electrodes 22 for the gates are formed above the semiconductor substrate 10 with a gate insulating film 21 sandwiched therebetween. Wiring layers 23, 24, and 25 are formed above the polysilicon transfer electrodes 22 with the respective interlayer insulating films sandwiched therebetween. The wiring film of the upper wiring layer 25 serves as a light-shielding film. A color filter 41 and a microlens 42 are arranged above the multiple wiring layers with a protective film (SiN) 30 sandwiched therebetween.

Since the pixels are manufactured in the same CMOS process as in the peripheral circuit in the CMOS image sensor, it may be impossible to cause the light-shielding film (wiring layer 25) to come close to the photodiode 13 and to form a structure in which the light is incident only on the photodiode 13. In contrast, the light-shielding film is formed of a metal layer, for example, an aluminum layer in a CCD image sensor, it is possible to cause the light-shielding film to come close to the photodiode to relatively suppress the light filtering into the vertical transfer register. Furthermore, since the CMOS image sensor has the multiple metal wiring layers and the light diffusely reflects from the multiple layers, the CMOS image sensor has a problem in that an larger amount of light filters into the FD 15, compared with the CCD solid-state image sensor.

As described above, a relatively larger amount of light filters into the FD in the CMOS solid-state image sensor. Since the photoelectric conversion is performed also in the FD, the charge corresponding to the amount of the filtering light is added to the signal voltage transferred to the FD to produce noise and cause shading, thus greatly degrading the quality of the captured image. When light has a higher-intensity, the amount of saturated signal is exceeded to produce portions filled with white in the image. In the CMOS image sensor in Fig. 2, the first row differs from the last row in the time period between when the charge is simultaneously transferred from the photodiodes to the FDs for all the pixels and when the charge is read out from the FDs by an amount corresponding to the readout time of one frame and, therefore, the amount of noise increases toward the last row to greatly degrade the image.

In addition, when the signal charge is held in the FD, as in the CMOS image sensor shown in Fig. 2, dark current has a greater effect on the CMOS image sensor, compared with the case in which the signal charge is held in the photodiode, to increase dark noise and to degrade the image quality.

Furthermore, since the pixel circuit in Fig. 2 includes the drain transistor, there is a problem in that the opening area is reduced to decrease the sensitivity.

It is desirable to provide an imaging apparatus configured to prevent distortion in an image captured by a solid-state image sensor adopting the XY address method and to suppress the amount of noise caused by light filtering into the pixel circuit.

It is also desirable to provide an imaging method capable of preventing distortion in an image captured by a solid-state image sensor adopting the XY address method and of suppressing the amount of noise caused by light filtering into the pixel circuit.

The problems are solved by an imaging apparatus according to claim 1 and an imaging method according to claim 5 of the present invention.

According to an example of the present invention, an imaging apparatus using a solid-state image sensor that reads out a signal of each pixel by an XY address method to capture an image includes a mechanical shutter configured to block light incident on a light receiving surface of the solid-state image sensor; and control means for simultaneously resetting the pixel signals for all rows in the solid-state image sensor to start exposure to the solid-state image sensor, closing the mechanical shutter after a predetermined exposure period is elapsed, and sequentially reading out the pixel signals for every row of the solid-state image sensor with the mechanical shutter being closed.

In such an imaging apparatus, simultaneously resetting the pixel signals of the solid-state image sensor for all the rows to start the exposure to the solid-state image sensor and, then, closing the mechanical shutter synchronize the exposure periods for all the rows. In addition, sequentially reading out the pixel signals of the solid-state image sensor for every row with the mechanical shutter being closed avoids a phenomenon in which light filters into the circuit in the solid-state image sensor.

According to another example of the present invention, an imaging method for using a solid-state image sensor that reads out a signal of each pixel by an XY address method to capture an image includes the steps of simultaneously resetting the pixel signals for all rows in the solid-state image sensor to start the exposure to the solid-state image sensor by control means, the step being referred to as an exposure starting step; and closing the mechanical shutter after a predetermined exposure period is elapsed to block light incident on a light receiving surface of the solid-state image sensor and sequentially reading out the pixel signals for every row of the solid-state image sensor with the mechanical shutter being closed, by the control means, the step being referred to as an exposure terminating step.

With such an imaging method, simultaneously resetting the pixel signals of the solid-state image sensor for all the rows to start the exposure to the solid-state image sensor in the exposure starting step and, then, closing the mechanical shutter in the exposure terminating step synchronize the exposure periods for all the rows. In addition, in the exposure terminating step, sequentially reading out the pixel signals of the solid-state image sensor for every row with the mechanical shutter being closed avoids a phenomenon in which light filters into the circuit in the solid-state image sensor.

According to the present example, since the pixel signals of the solid-state image sensor are simultaneously reset for all the rows to start the exposure to the solid-state image sensor and, then, the mechanical shutter is closed in order to synchronize the exposure periods for all the rows, no distortion occurs in the captured image. In addition, since the pixel signals of the solid-state image sensor are sequentially read out for every row with the mechanical shutter being closed to avoid a phenomenon in which light filters into the circuit in the solid-state image sensor, noise due to the filtering light is not produced in the captured image. Accordingly, the quality of the image captured by the solid-state image sensor adopting the XY address method can be improved.

### BRIEF DESCRIPTION OF THE DRAWINGS

Fig. 1A shows exposure and charge transfer timings in a related art when a rolling shutter is used;
Fig. 1B shows an image captured at the timings in Fig. 1A;
Fig. 2 shows an example of the configuration of each pixel circuit in a CMOS image sensor capable of simultaneously triggering a shutter for all the rows;
Fig. 3A shows exposure and charge transfer timings in the pixel circuit in Fig. 2;
Fig. 3B shows an image captured at the timings in Fig. 3A;
Fig. 4 is a cross-sectional view showing an example of the structure of an area near to a photodiode in a CMOS image sensor in a related art;
Fig. 5 is a block diagram showing an example of the structure of an imaging apparatus according to an embodiment of the present invention;
Fig. 6 is a block diagram schematically showing an example of the structure of an imaging device and an analog circuit peripheral to the imaging device;
Fig. 7 shows an example of the configuration of each pixel circuit in a pixel area in the imaging device;
Fig. 8 is a timing chart showing a shutter operation in monitoring of a captured image and in capture of a motion picture;
Fig. 9 is a timing chart showing a shutter operation in capture of a still image;
Fig. 10 is a timing chart showing a shutter operation in continuous capture of still images every 1/30 second;
Fig. 11 shows an example of the structure of a mechanical shutter appropriate for the operation shown in Fig. 10; and
Fig. 12 illustrates the operation of the mechanical shutter shown in Fig. 11.

### DESCRIPTION OF THE PREFERRED EMBODIMENTS

Embodiments of the present invention will be described in detail with reference to the attached drawings. A digital still camera is exemplified as an imaging apparatus in the following description.

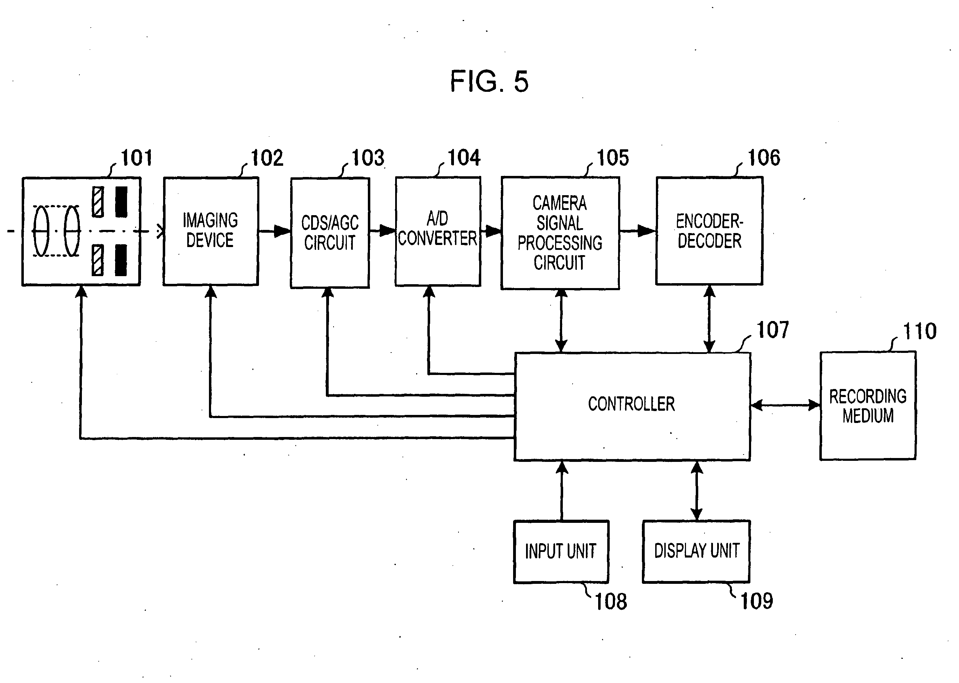

Fig. 5 is a block diagram showing an example of the structure of an imaging apparatus according to an embodiment of the present invention.

The imaging apparatus in Fig. 5 includes an optical block 101, an imaging device 102, a corrected double sampling/auto gain control (CDS/AGC) circuit 103, an analog-to-digital (A/D) converter 104, a camera signal processing circuit 105, an encoder-decoder 106, a controller 107, an input unit 108, a display unit 109, and a recording medium 110.

The optical block 101 includes lenses used for gathering light reflected from an object into the imaging device 102, a driving mechanism that moves the lenses to perform focusing and zooming, a mechanical shutter mechanism, an iris mechanism, and so on, which are not shown in Fig. 5. Movable parts in the above components are driven in response to control signals supplied from the controller 107. The mechanical shutter mechanism may be integrated with the iris mechanism.

The imaging device 102 is a solid-state image sensor adopting the XY address method, such as a CMOS image sensor. Timings of exposure, signal readout, and reset in the imaging device 102 are controlled in response to control signals supplied from the controller 107.

The CDS/AGC circuit 103 and the A/D converter 104 are front-end circuits operating under the control of the controller 107. The CDS/AGC circuit 103 eliminates noise having a fixed pattern, caused by a variation in thresholds of transistors in the pixel circuits, by CDS processing in response to signals output from the imaging device 102, performs sample hold so as to ensure a desirable signal/noise (S/N) ratio, and controls gains by AGC processing. The A/D converter 104 converts an analog image signal supplied from the CDS/AGC circuit 103 into a digital image signal.

The camera signal processing circuit 105 performs camera signal processing, such as white balance adjustment, color correction, autofocusing (AF), and auto-exposure (AE), for the digital image signal resulting from the conversion in the A/D converter 104 under the control of the controller 107.

The encoder-decoder 106 operates under the control of the controller 107 to perform compression and encoding in a predetermined still-image data format, for example, Joint Photographic Experts Group (JPEG) format, for the image signal supplied from the camera signal processing circuit 105. The encoder-decoder 106 also performs decompression and decoding for encoded data of a still image supplied from the controller 107. The encoder-decoder 106 may be capable of performing the compression and encoding/decompression and decoding of a motion picture in Moving Picture Experts Group (MPEG) format or the like.

The controller 107 is a microcontroller including, for example, a central processing unit (CPU), a read only memory (ROM), and a random access memory (RAM). The controller 107 executes programs stored in the ROM or the like to control the components in the imaging apparatus.

The input unit 108 includes various operation keys including a shutter release button, a lever, and a dial, and supplies a control signal in accordance with an input operation by a user to the controller 107.

The display unit 109 includes a display device, such as a liquid crystal display (LCD), and the corresponding interface circuit. The display unit 109 generates an image signal used for display in the display device from the image signal supplied from the controller 107 and supplies the generated image signal to the display device to display an image.

The recording medium 110 is embodied by, for example, a portable semiconductor memory, an optical disc, a hard disk drive (HDD), or a magnetic tape. The recording medium 110 receives a file including the image data encoded by the encoder-decoder 106 through the controller 107 and stores the received file. The recording medium 110 also reads out specified data on the basis of a control signal supplied from the controller 107 and supplies the readout data to the controller 107.

A basic operation in the imaging apparatus will now be described.

Before a still image is captured, an image signal output from the imaging device 102 is sequentially supplied to the CDS/AGC circuit 103 to be subjected to the CDS processing and the AGC processing, and the processed image signal is converted into a digital signal in the A/D converter 104. The camera signal processing circuit 105 performs image quality correction for the digital image signal supplied from the A/D converter 104 and supplies the digital image signal to the display unit 109 through the controller 107 as a signal of a camera through image. The camera through image is displayed in the display unit 109 and the user can watch the displayed image to adjust the angle of view.

When the shutter release button in the input unit 108 is pressed in this state, a captured signal corresponding to one frame, supplied from the imaging device 102, is supplied to the camera signal processing circuit 105 through the CDS/AGC circuit 103 and the A/D converter 104 under the control of the controller 107. The camera signal processing circuit 105 performs the image quality correction for the image signal corresponding to one frame and supplies the image signal subjected to the image quality correction to the encoder-decoder 106. The encoder-decoder 106 compresses and encodes the received image signal and supplies the encoded data to the recording medium 110 through the controller 107. The recording medium 110 stores a data file including the captured still image.

In order to reproduce the data file including the still image recorded in the recording medium 110, the controller 107 reads out a selected data file from the recording medium 110 in response to an input operation with the input unit 108 and supplies the read data file to the encoder-decoder 106 to cause the encoder-decoder 106 to perform the decompression and decoding. The decoded image signal is supplied to the display unit 109 through the controller 107, and the display unit 109 displays the reproduced still image.

In order to record a motion picture, image signals sequentially processed in the camera signal processing circuit 105 are subjected to the compression and encoding in the encoder-decoder 106, and the encoded data of the motion picture is sequentially transferred to the recording medium 110 and is recoded in the recording medium 110. In order to display a motion picture, a data file of the motion picture is read out from the recording medium 110, the readout data file is supplied to the encoder-decoder 106 for the decompression and decoding, and the decoded motion picture is supplied to the display unit 109 and is displayed in the display unit 109.

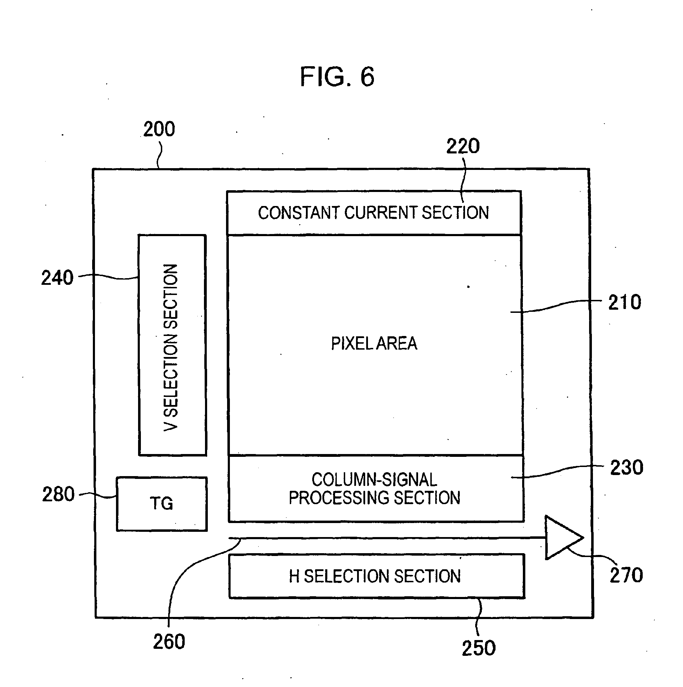

Fig. 6 is a block diagram schematically showing an example of the structure of the imaging device 102 and an analog circuit peripheral to the imaging device 102.

Referring to Fig. 6, the imaging device 102 (CMOS image sensor) according to this embodiment of the present invention has a pixel area (an image capturing area) 210, a constant current section 220, a column-signal processing section 230, a vertical (V) selection section 240, a horizontal (H) selection section 250, a horizontal signal line 260, an output processing section 270, and a timing generator (TG) 280, which are provided on a semiconductor device substrate 200.

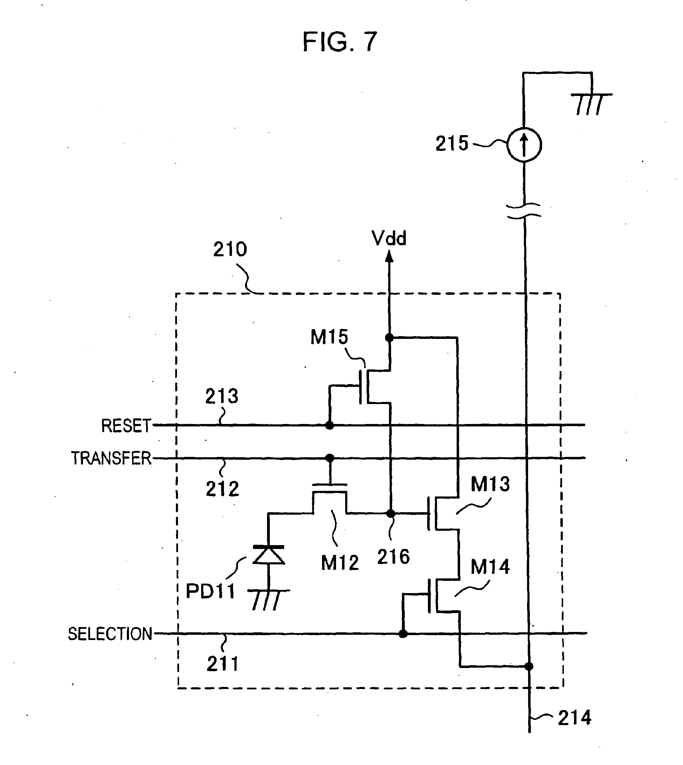

The pixel area 210 has a plurality of pixels arranged in a two-dimensional matrix. Each pixel has a pixel circuit described below with reference to Fig. 7. Signals of the pixels, output from the pixel area 210, are supplied to the column-signal processing section 230 through a vertical signal line (not shown) for every pixel column.

The constant current section 220 includes constant current sources that supply bias current to the pixels and that are arranged for every pixel column. The vertical selection section 240 selects pixels in the pixel area 210 for every row to drive and control the shutter operation and the readout operation for the pixels.

The column-signal processing section 230 receives signals of the pixels for every row through the vertical signal line, performs predetermined signal processing for the pixels for every column, and temporarily stores the processed signals. The column-signal processing section 230 appropriately performs, for example, the CDS processing, the AGC processing, and the AD conversion. The horizontal selection section 250 selects the signals supplied from the column-signal processing section 230 one by one and outputs the selected signals to the horizontal signal line 260.

The output processing section 270 performs predetermined processing for the signals supplied through the horizontal signal line 260 and externally outputs the processed signals. The output processing section 270 includes, for example, a gain control circuit and a color processing circuit. The output processing section 270 may perform the AD conversion, instead of the column-signal processing section 230. The TG 280 outputs various pulse signals required for the operation of the components, in synchronization with a reference clock under the control of the controller 107.

Fig. 7 shows an example of the configuration of each pixel circuit in the pixel area 210 in the imaging device 102.

Referring to Fig. 7, each pixel circuit in the pixel area 210 includes a photodiode PD11, a transfer transistor M12, an amplification transistor M13, a selection transistor M14, and a reset transistor M15. Each transistor is an n-channel MOSFET.

A row selection signal line 211, a transfer signal line 212, and a reset signal line 213 are connected to the gates of the selection transistor M14, the transfer transistor M12, and the reset transistor M15, respectively. These signal lines horizontally extend to simultaneously drive the pixels in the same row in order to control a rolling shutter operation in which the pixels are sequentially operated for every row and a global shutter operation in which all the pixels are simultaneously operated. A vertical signal line 214 is connected to the source of the selection transistor M14. One end of the vertical signal line 214 is grounded via a constant current source 215.

The photodiode PD11 has electric charge, generated by photoelectric conversion, accumulated therein. The P semiconductor end of the photodiode PD11 is grounded and the N semiconductor end thereof is connected to the source of the transfer transistor M12. When the transfer transistor M12 is turned on, the charge in the photodiode PD11 is transferred to a FD 216. Since the FD 216 has a parasitic capacitance, the charge is accumulated in the FD 216.

A power supply voltage Vdd is applied to the drain of the amplification transistor M13, and the gate of the amplification transistor M13 is connected to the FD 216. The amplification transistor M13 converts a variation in voltage in the FD 216 into an electrical signal. The selection transistor M14 selects a pixel from which a signal is read out for every row. The drain of the selection transistor M14 is connected to the source of the amplification transistor M13, and the source thereof is connected to the vertical signal line 214. Since the amplification transistor M13 and the constant current source 215 form a source follower when the selection transistor M14 is turned on, a voltage associated with the voltage of the FD 216 is output to the vertical signal line 214.

The power supply voltage Vdd is applied to the drain of the reset transistor M15, and the source of the reset transistor M15 is connected to the FD 216. The reset transistor M15 resets the voltage of the FD 216 to the power supply voltage Vdd.

A basic operation of the pixel area 210 will now be described. The pixel circuits in the pixel area 210 are capable of performing the two types of electronic shutter operations including the rolling shutter operation and the global shutter operation.

In the rolling shutter operation, the pixel circuits in each row in the pixel area 210 supply a pulse signal to the reset signal line 213 and the transfer signal line 212 to turn on the reset transistor M15 and the transfer transistor M12. After the FD 216 and the photodiode PD11 are reset, an exposure period of the photodiode PD11 is started upon turning off of the reset transistor M15 and the transfer transistor M12.

Immediately before the exposure period is terminated, a high voltage is applied to the reset signal line 213 for the row to turn on the reset transistor M15, and the voltage of the FD 216 is set to the power supply voltage Vdd. A high voltage is applied to the row selection signal line 211 for the row in this state to turn on the selection transistor M14, and a voltage corresponding to the reset voltage of the FD 216 is output to the vertical signal line 214. After a low voltage is applied to the reset signal line 213 to turn off the reset transistor M15, a high voltage is applied to the transfer signal line 212 to turn on the transfer transistor M12. This terminates the exposure period, a voltage in proportion to the charge accumulated in the photodiode PD11 is transferred to the FD 216, and the voltage of the FD 216 is output to the vertical signal line 214.

The difference between the voltage corresponding to the reset voltage and the voltage corresponding to the voltage in proportion to the accumulated charge becomes a signal voltage that is extracted in the CDS processing in the column-signal processing section 230 for the corresponding column. The columns are sequentially selected by the horizontal selection section 250 and the pixel signals for one row are output.

After the selection transistor M14 and the transfer transistor M12 for the row are turned off, the reset transistor M15 and the transfer transistor M12 are turned on and, after the reset transistor M15 and the transfer transistor M12 are turned off, the subsequent exposure period is started. The above operation is performed for every row, from the first row, with time delay in synchronization with a horizontal synchronization signal to sequentially output the pixel signals for each row. Accordingly, the exposure periods of the rows are shifted from each other.

In the global shutter operation, the turning on of the reset transistor M15 and the transfer transistor M12 and the resetting of the FD 216 and the photodiode PD11 are simultaneously performed for all the rows to simultaneously start the exposure periods for all the rows.

After the exposure periods are terminated, the mechanical shutter is used in a manner described below according to the embodiment of the present invention. The charge accumulated in the photodiode PD11 is sequentially transferred to the FD 216 for every row and the signal voltage is output to the vertical signal line 214 for every row, as in the rolling shutter operation.

Since the exposure is performed at different times for every row in the electronic shutter operation in the rolling shutter mode, as described above, there is a problem in that a still image captured in the rolling shutter mode is distorted. For example, when an object moving in the horizontal direction in a screen is captured, the originally vertical straight line is tilted in the captured still image.

In contrast, according to the embodiment of the present invention, the exposure is simultaneously started for all the rows in the global shutter mode and, then, the mechanical shutter (or the iris) in the optical block 101 is closed to terminate the exposure in order to synchronize the exposure periods for all the rows. In addition, closing the mechanical shutter after the exposure is terminated avoids a phenomenon in which light reflected from the object filters into the photodiode PD11 and the FD 216 after the exposure is terminated before the pixel signal is output to the vertical signal line 214.

### Control Example 1 of Shutter Operation

In the control example 1, the electronic shutter operation in the rolling shutter mode is performed in monitoring of a captured image (in display of a camera through image) and in capture of a motion picture, whereas both the reset operation in the global shutter mode and the exposure-time control operation with the mechanical shutter are used in capture of a still image.

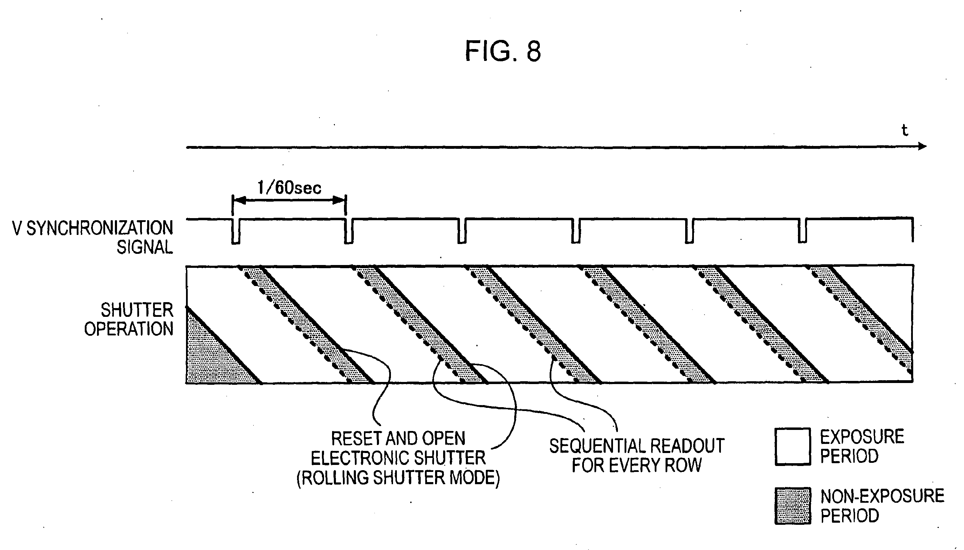

Fig. 8 is a timing chart showing a shutter operation in the monitoring of a captured image and in the capture of a motion picture.

It is assumed in Fig. 8 that interlace readout of 30 frames (60 fields) per second is performed. In this case, an image signal corresponding to one field is output from the imaging device 102 in 1/60 second. As shown in Fig. 8, after a vertical synchronization signal falls, the FDs 216 and the photodiodes PD11 are sequentially reset for every row in the rolling shutter mode at predetermined timings corresponding to the exposure periods. At the subsequent falling timing of the vertical synchronization signal, sequential readout of the accumulated charge for every row is started. In the example in Fig. 8, the reset operation and the readout operation are performed every row, and the operation of even-numbered rows and the operation of odd-numbered rows are alternately performed every vertical synchronization period to realize the interlace readout.

Such operations cause the exposure periods for the rows to be shifted from each other in the imaging device 102. However, the vertical distortion of the image on the screen is not highly visible because screen switching is performed at high speed in the display of a camera through image and in the reproduction and display of a recorded motion picture. Hence, the shutter operation in the rolling shutter mode is performed without using the mechanical shutter.

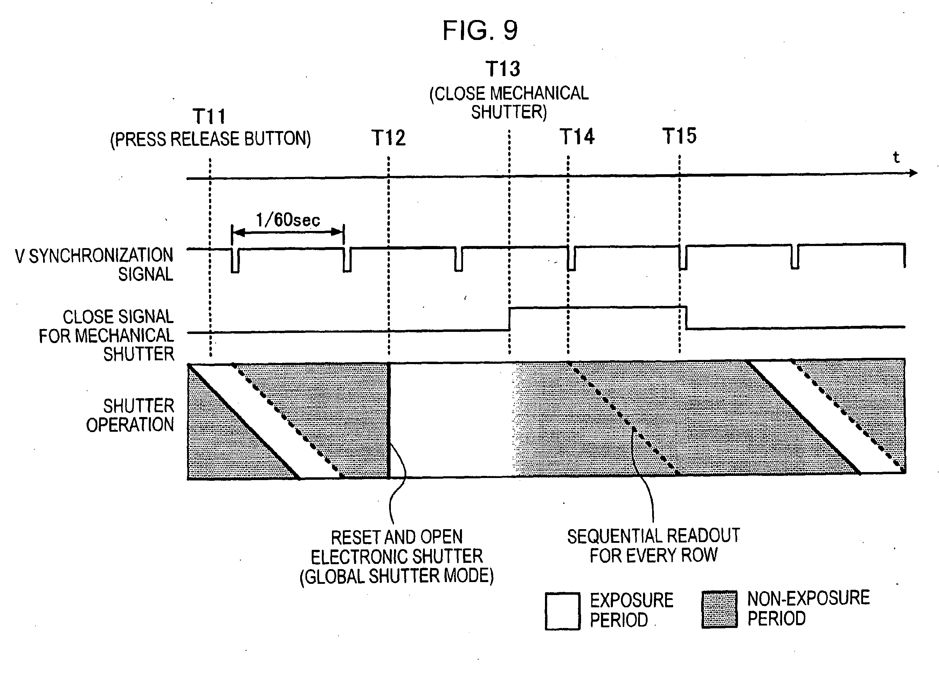

Fig. 9 is a timing chart showing a shutter operation in the capture of a still image.

When the shutter release button in the input unit 108 is pressed with a camera through image being displayed (a timing T11), the exposure control mode in the controller 107 is moved from the monitoring/motion-picture capturing mode, shown in Fig. 8, to the still-image capturing mode and, after the pixel signals are sequentially read out for every row at the subsequent vertical synchronization timing, the subsequent vertical synchronization signal is waited for without performing the reset operation in the rolling shutter mode.

After the subsequent vertical synchronization signal is received, the reset operation in the global shutter mode is simultaneously performed for all the rows at a predetermined timing corresponding to the exposure period (a timing T12). This starts the exposure period. The use of the electronic shutter allows the exposure period to be precisely controlled, compared with a case where the exposure is started by operating, for example, the mechanical shutter.

Upon termination of the exposure period, the controller 107 sets the voltage of a close signal used for specifying whether the mechanical shutter is closed to a higher level to close the mechanical shutter (a timing T13). The closing of the mechanical shutter causes the light incident on the photodiodes PD11 and the FDs 216 for all the pixels to be completely blocked. At the subsequent vertical synchronization timings, the transfer of the accumulated charge from the photodiodes PD11 to the FDs 216 and the readout of the signal charge are sequentially performed for every row (timings T14 to T15). The readout of the signal charge from all the rows is continuously performed. Upon completion of the readout of the signal charge from all the rows, the controller 107 sets the voltage of the close signal to a lower level to open the mechanical shutter.

In the above shutter operation, the exposure period is started by opening the electronic shutter in the global shutter mode and the exposure period is terminated by closing the mechanical shutter. Accordingly, the exposure periods for all the rows are synchronized with each other and, therefore, no distortion occurs in the captured image.

In addition, the light incident on the photodiodes PD11 and the FDs 216 is completely blocked by the mechanical shutter after the exposure period is terminated before all the pixel signals are read out. Hence, no noise due to the light filtering into the photodiodes PD11 and the FDs 216 is produced to improve the quality of the captured image.

When the charge accumulated in the photodiode PD11 is transferred to the FD 216 after the mechanical shutter is closed, in the shutter operation in the capture of the still image, the accumulated charge for all the rows may be simultaneously transferred. In such a case, after the voltage corresponding to the accumulated charge is output from the FD 216 to the vertical signal line 214, the reset transistor M15 is turned on to output the voltage corresponding to the reset voltage from the FD 216 to the vertical signal line 214 in order to extract the signal voltage.

However, the sequential transfer of the accumulated charge to the FD 216 for every row, instead of the simultaneous transfer, and the readout of the signal charge in a short time after the transfer shorten the period during which the signal charge is accumulated in the FD 216. As a result, the effect of the dark current on the pixel signal and the amount of the dark noise produced in the captured image is reduced to improve the image quality.

Furthermore, performing the transfer of the accumulated charge to the FD 216 for every row eliminates the need for the drain transistor used for discharging the excessive charge in the photodiode PD11 before the exposure is started, unlike the pixel circuit in the related art shown in Fig. 2, and allows the pixel circuit having a common circuit configuration shown in Fig. 7 to be used. Accordingly, the number of circuit elements is decreased to reduce the manufacturing cost of the circuit, and the opening area in the light receiving surface is increased to increase the amount of incident light and to capture an image having a higher brightness.

When the exposure period is relatively long, for example, is no less than 0.1 second in the capture of the still image, a captured image of a moving object is distorted. In such a case, the distortion of the captured image, caused by the shutter operation, does not have much effect on the image quality even in the shutter operation in the rolling shutter mode. Accordingly, the shutter operation may be controlled by the use of both the global shutter and the mechanical shutter, as shown in Fig. 9, only if the exposure period calculated by the camera signal processing circuit 105 or the controller 107 is no more than a predetermined value when the shutter release button is pressed and, otherwise, the shutter operation may be controlled by the use of the rolling shutter. Such control suppresses excessive operation of the mechanical shutter to reduce the power consumption.

### Control Example 2 of Shutter Operation

The control of the shutter operation by the use of both the global shutter and the mechanical shutter, shown in Fig. 9, is not limited to the case where the still image corresponding to one frame is captured. The shutter operation may be controlled by the use of both the global shutter and the mechanical shutter also in continuous capture of still images and in capture of a motion picture.

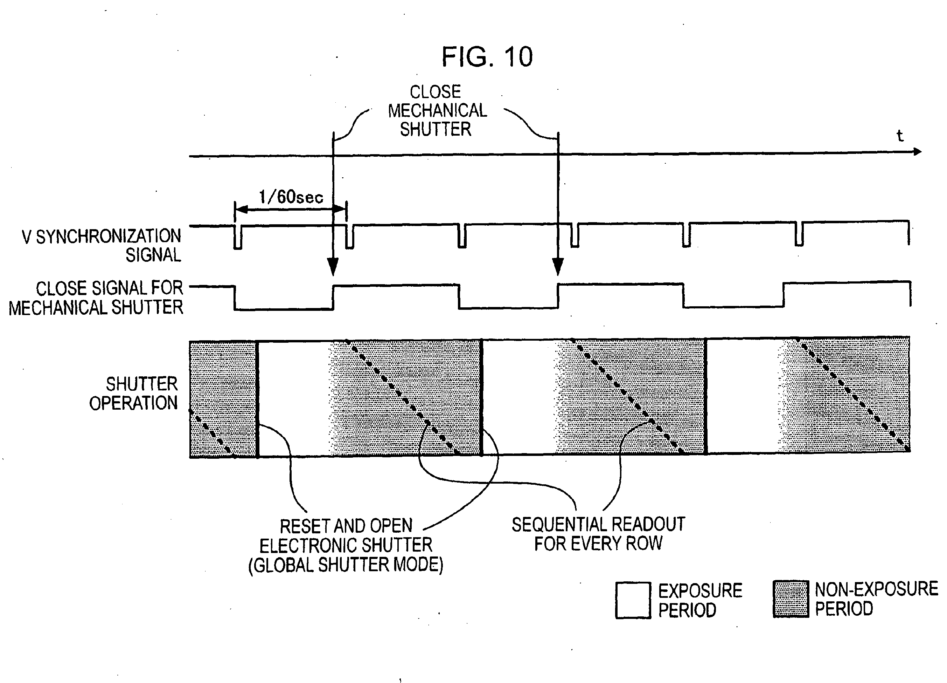

Fig. 10 is a timing chart showing a shutter operation in the continuous capture of still images every 1/30 second.

In the control example in Fig. 10, the exposure period is set within one vertical synchronization period (no more than 1/60 second) and the pixel signals for all the rows are read out during the subsequent vertical synchronization period to output the image signal corresponding to one frame every 1/30 second. In other words, the reset operation for all the rows is simultaneously performed in the global shutter mode at a predetermined timing after the vertical synchronization signal is received to start the exposure period. The mechanical shutter is closed by a time when the subsequent vertical synchronization signal is received to terminate the exposure period. After the subsequent vertical synchronization signal is received, the transfer of the accumulated charge from the photodiodes PD11 to the FDs 216 and the readout of the signal voltage from the FDs 216 are sequentially performed for every row. After the further subsequent vertical synchronization signal is received, the exposure is started again at a predetermined timing.

The above operation achieves an image having no distortion and reduced noise but higher quality even in the continuous capture of the still image and the capture of the motion picture.

In order to perform such a shutter operation, there is a need to use a mechanical shutter capable of accurately operating at a higher speed every about 1/60 second.

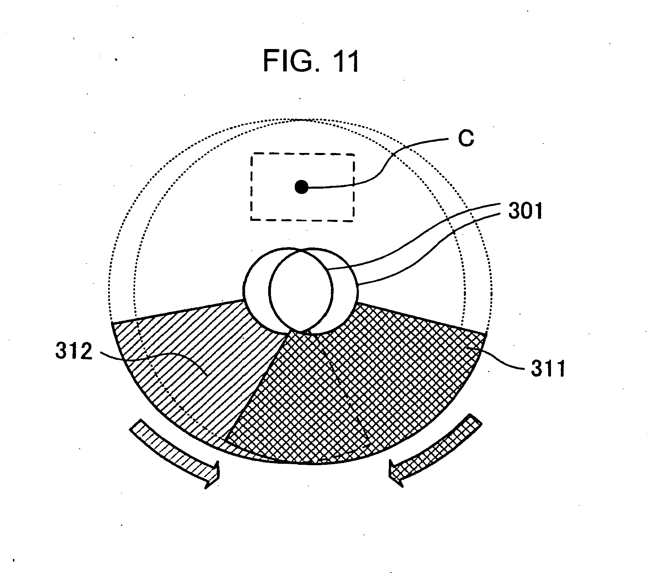

Fig. 11 shows an example of the structure of a mechanical shutter appropriate for the operation shown in Fig. 10.

The mechanical shutter in Fig. 11 has two sectorial light shielding members 311 and 312 rotating abound central axes 301. The light shielding members 311 and 312 have the same radius from the central axes 301 and the same length of a curved perimeter, and the light shielding member 311 rotates at the same speed as the light shielding member 312 in a direction opposite to that of the light shielding member 312. The optical axis C of the optical system is set at a position in the area where the light shielding members 311 and 312 pass through to cause a predetermined area around the optical axis C to be opened or closed in accordance with the rotation of the light shielding members 311 and 312.

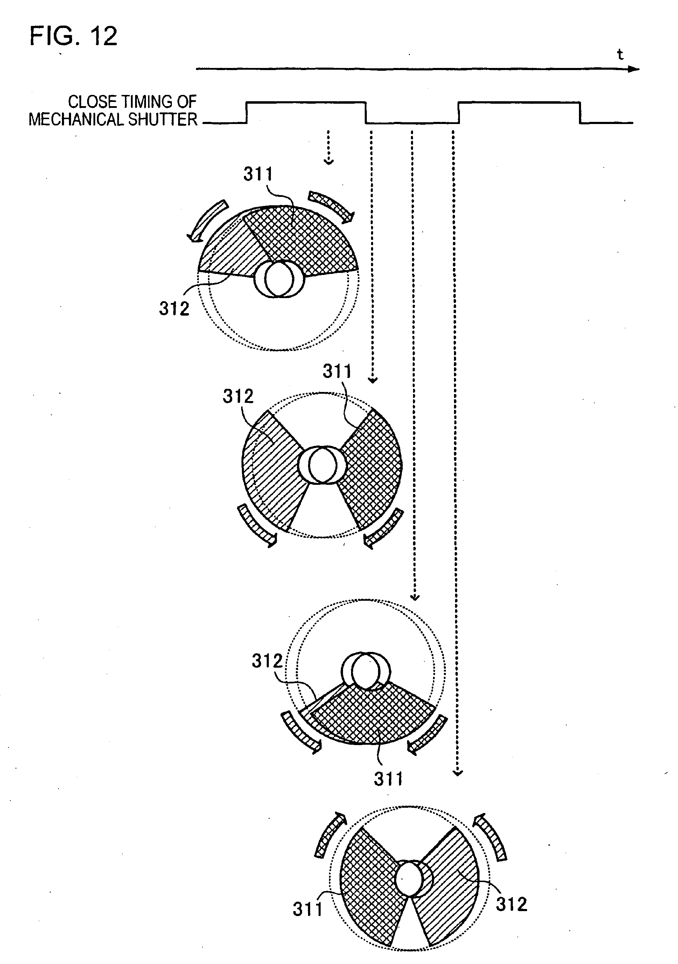

Fig. 12 illustrates the operation of the mechanical shutter shown in Fig. 11.

To realize the operation shown in Fig. 11, it is sufficient to close the mechanical shutter during a predetermined time period every 1/30 second. Such an operation of the mechanical shutter can be realized by rotating the light shielding members 311 and 312 at a predetermined speed (one rotation per 1/30 second) in opposite directions, as shown in Fig. 12. A time period during which the mechanical shutter is closed is determined in accordance with an angle between the straight lines at both ends of the light shielding members 311 and 312 with respect to the central axes 301. Such a mechanical shutter having a simple structure can realize a stable and highspeed shutter operation.

The present invention is not limited to the CMOS image sensor described above. The present invention is applicable to solid-state image sensors, such as other MOS image sensors, capable of accumulating the signal charge in the photodiode in the floating diffusion and reading out the pixel signal by the XY address method.

Although the present invention is applied to the digital still camera in the above embodiments of the present invention, the present invention is not limited to these cases. For example, the present invention is applicable to a digital video camera, and also to a mobile phone or a personal digital assistant (PDA), which has a function of capturing a still image and a motion picture.

It should be understood by those skilled in the art that various modifications, combinations, sub-combinations and alterations may occur depending on design requirements and other factors insofar as they are within the scope of the appended claims.

## Claims

1. An imaging apparatus using a solid-state image sensor (102) that reads out a signal of each pixel by an XY address method to capture an image, the imaging apparatus comprising:
- a mechanical shutter configured to block light incident on a light receiving surface of the solid-state image sensor (102);
- control means (107) for
simultaneously resetting the pixel signals for all rows in the solid-state image sensor (102) to start exposure to the solid-state image sensor (102),
closing the mechanical shutter after a predetermined exposure period is elapsed, and
sequentially reading out the pixel signals for every row of the solid-state image sensor (102) with the mechanical shutter being closed, and
- an exposure-period detecting means for calculating an exposure period based on a signal output from the solid-state image sensor (102),
wherein, if the calculated exposure period is smaller than or equal to a predetermined threshold value when a request to capture the still image is received, the control means controls the operation of capturing the still image by a first shutter operation control and,
otherwise, the control means controls the operation of capturing the still image by a second shutter operation control,
wherein in the first shutter operation control the pixel signals are simultaneously reset for all the rows to start the exposure to the solid-state image sensor (102), the mechanical shutter is closed after the predetermined exposure period is elapsed and the pixel signals are sequentially read out for every row of the solid-state image sensor (102) with the mechanical shutter being closed,
and wherein in the second shutter operation control an operation of resetting the pixel signals to start the exposure to the corresponding row in the solid-state image sensor (102) and an operation of reading out the pixel signals for the corresponding row after the predetermined exposure period is elapsed are performed every row.

2. The imaging apparatus according to Claim 1, wherein each pixel in the solid-state image sensor (102) includes:
a photoelectric transducer configured to generate signal charge corresponding to the amount of received light;
a floating diffusion configured to detect an amount of the signal charge generated by the photoelectric transducer;
a transfer transistor (M12) configured to transfer the signal charge generated by the photoelectric transducer to the floating diffusion; and
a reset transistor (M15) configured to reset the voltage of the floating diffusion to a predetermined level, and
wherein, when the exposure to the solid-state image sensor (102) is started, the control means (107) turns on the transfer transistor (M12) and the reset transistor (M15) to reset the signal charge accumulated in the photoelectric transducer and the voltage of the floating diffusion
and, after the mechanical shutter is closed, the control means (107) sequentially reads out the voltages corresponding to the signal charge transferred from the photoelectric transducer from the floating diffusion for every row.

3. The imaging apparatus according to Claim 2,
wherein the control means (107) are arranged so as to, after the mechanical shutter is closed, further sequentially turn on the transfer transistors (M12) for every row to transfer the signal charge in the photoelectric transducer to the floating diffusion and to read out the voltage corresponding to the transferred signal charge from the floating diffusion.

4. The imaging apparatus according to one of Claims 1 to 3,
wherein, for performing the first shutter operation control by the control means
the mechanical shutter has two sectorial light shielding members (311, 312) having the same central axis (301), shape, and size and
the mechanical shutter is structured so as to selectively block the light incident on the solid-state image sensor (102), the light passing through a position in an area where the light shielding members pass through, by overlapping the two light shielding members (311, 312) with each other and rotating the light shielding members (311, 312) around the central axis (301) at the same predetermined speed in opposite directions.

5. An imaging method for using a solid-state image sensor (102) that reads out a signal of each pixel by an XY address method to capture an image, the imaging method comprising
- an exposure starting step comprising
simultaneously resetting the pixel signals for all rows in the solid-state image sensor (102) to start exposure to the solid-state image sensor (102) by control means (107),
- an exposure terminating step comprising the steps of
closing the mechanical shutter after a predetermined exposure period is elapsed to block light incident on a light receiving surface of the solid-state image sensor (102) and
sequentially reading out the pixel signals for every row of the solid-state image sensor (102) with the mechanical shutter being closed
- receiving an image capture request in response to an input operation by a user by the control means (107),
- calculating an exposure period based on a signal output from the solid-state image sensor (102),
wherein, if the calculated exposure period is smaller than or equal to a predetermined threshold value when a request to capture the still image is received, performing the exposure starting step and the exposure terminating step, and
otherwise, performing a sequential exposure step,
wherein the sequential exposure step comprises performing an operation of resetting the pixel signals to start the exposure to the corresponding row in the solid-state image sensor (102) and an operation of reading out the pixel signals for the corresponding row after the predetermined exposure period is elapsed, every row.

6. The imaging method according to Claim 5, wherein in each pixel in the solid-state image sensor (102)
a photoelectric transducer generates signal charge corresponding to the amount of received light;
a floating diffusion detects an amount of the signal charge generated by the photoelectric transducer;
a transfer transistor (M12) transfers the signal charge generated by the photoelectric transducer to the floating diffusion; and
a reset transistor (M15) resets the voltage of the floating diffusion to a predetermined level,
wherein, in the exposure starting step, the control means (107) turns on the transfer transistor (M12) and the reset transistor (M15) to reset the signal charge accumulated in the photoelectric transducer and the voltage of the floating diffusion, and
wherein, in the exposure terminating step, after the mechanical shutter is closed, the control means (107) sequentially reads out the voltages, corresponding to the signal charge transferred from the photoelectric transducer, from the floating diffusion for every row.

7. The imaging method according to Claim 6, wherein the exposure terminating step further comprises sequentially turning on the transfer transistors (M12) for every row, after the mechanical shutter is closed, to transfer the signal charge in the photoelectric transducer to the floating diffusion and reading out the voltage corresponding to the transferred signal charge from the floating diffusion.

## Patentansprüche

1. Abbildungsvorrichtung, welche einen Festkörperbildsensor (102) verwendet, der ein Signal eines jeden Pixels mittels eines XY-Adressverfahrens ausliest, um ein Bild aufzunehmen,
wobei die Abbildungsvorrichtung aufweist:
- einen mechanischen Verschluss, der ausgebildet ist, auf eine Lichtempfangsfläche des Festkörperbildsensors (102) einfallendes Licht zu blockieren,
- eine Steuereinrichtung (107) zum
gleichzeitigen Rücksetzen der Pixelsignale für sämtliche Zeilen im Festkörperbildsensors (102), um eine Belichtung des Festkörperbildsensors (102) zu beginnen,
Schließen des mechanischen Verschlusses, nachdem eine vorbestimmte Belichtungszeitspanne verstrichen ist, und
sequentielles Auslesen der Pixelsignale für jede Zeile des Festkörperbildsensors (102) bei geschlossenem mechanischem Verschluss,
und
- eine Belichtungszeitspannenbestimmungseinrichtung zum Berechnen einer Belichtungszeitspanne auf der Grundlage eines vom Festkörperbildsensor (102) ausgegebenen Signals,
wobei,
falls die berechnete Belichtungszeitspanne kleiner ist als oder gleich ist zu einem vorbestimmten Schwellwert, wenn eine Anfrage zur Aufnahme eines Standbildes empfangen wird, die Steuereinrichtung den Betrieb des Aufnehmens des Standbildes durch eine erste Verschlussbetriebssteuerung steuert, und
sonst die Steuereinrichtung den Betrieb des Aufnehmens des Standbildes durch eine zweite Verschlussbetriebssteuerung steuert,
wobei bei der ersten Verschlussbetriebssteuerung die Pixelsignale für alle Zeilen simultan rückgesetzt werden, um die Belichtung des Festkörperbildsensors (102) zu beginnen, wobei der mechanische Verschluss verschlossen wird, nachdem die vorbestimmte Belichtungszeitspanne verstrichen ist und die Pixelsignale sequentiell für jede Zeile im Festkörperbildsensors (102) bei geschlossenem mechanischem Verschluss ausgelesen werden, und
wobei bei der zweiten Verschlussbetriebssteuerung ein Vorgang des Rücksetzens der Pixelsignale, um das Belichten der korrespondierenden Zeile des Festkörperbildsensors (102) zu beginnen, und ein Vorgang des Auslesens der Pixelsignale in Bezug auf die korrespondierende Zeile, nachdem die vorbestimmte Belichtungszeitspanne verstrichen ist, für jede Zeile durchgeführt werden.

2. Abbildungsvorrichtung nach Anspruch 1,
wobei jedes Pixel im Festkörperbildsensor (102) aufweist:
einen fotoelektrischen Wandler, der ausgebildet ist, korrespondierend zur Menge empfangenen Lichts eine Signalladung zu erzeugen,
einen floatenden Diffusionsbereich, der ausgebildet ist, die Menge der vom fotoelektrischen Wandler erzeugten Signalladung zu detektieren,
einen Übertragungstransistor (M12), der ausgebildet ist, die vom fotoelektrischen Wandler erzeugte Signalladung zum floatenden Diffusionsbereich zu übertragen, und
einen Rücksetztransistor (M 15), der ausgebildet ist, die Spannung des floatenden Diffusionsbereichs auf ein vorbestimmtes Niveau rückzusetzen,
wobei, wenn die Belichtung des Festkörperbildsensors (102) begonnen wird, die Steuereinrichtung (107) den Übertragungstransistor (M12) und den Rücksetztransistor (M15) einschaltet, um die im fotoelektrischen Wandler akkumulierte Signalladung und die Spannung des floatenden Diffusionsbereichs rückzusetzen, und
wobei, nachdem der mechanische Verschluss geschlossen wurde, die Steuereinrichtung (107) die Spannungen, die zu der vom fotoelektrischen Wandler übertragenen Signalladung korrespondieren, aus dem floatenden Diffusionsbereich für jede Zeile sequentiell ausliest.

3. Abbildungsvorrichtung nach Anspruch 2,
wobei die Steuereinrichtung (107) ausgebildet ist, nachdem der mechanische Verschluss geschlossen wurde, des Weiteren sequentiell die Übertragungstransistoren (M12) für jede Zeile einzuschalten, um die Signalladung im fotoelektrischen Wandler zum floatenden Diffusionsbereich zu übertragen und die Spannung, die zu der übertragenen Signalladung korrespondiert, aus dem floatenden Diffusionsbereich auszulesen.

4. Abbildungsvorrichtung nach einem der Ansprüche 1 bis 3,
wobei zum Ausführen der ersten Verschlussbetriebssteuerung durch die Steuereinrichtung
der mechanische Verschluss zwei sektorielle Lichtabschirmelemente (311, 312) mit derselben Zentralachse (301), Gestalt und Größe aufweist und
der mechanische Verschluss aufgebaut ist, um selektiv das Licht zu blockieren, welches auf den Festkörperbildsensor (102) einfällt, wobei das Licht eine Position in einem Bereich passiert, wo die Lichtabschirmelemente hindurchtreten, und zwar durch Überlappen der beiden Lichtabschirmelemente (311, 312) miteinander und durch Rotieren der Lichtabschirmelemente (311, 312) um die Zentralachse (301) mit derselben vorbestimmten Geschwindigkeit in entgegen gesetzten Richtungen.

5. Abbildungsverfahren zur Verwendung in einem Festkörperbildsensor (102), welcher ein Signal jedes Pixels mittels eines XY-Adressverfahrens ausliest, um ein Bild aufzunehmen,
wobei das Abbildungsverfahren aufweist
- einen Schritt des Beginnens einer Belichtung mit
gleichzeitigem Rücksetzen der Pixelsignale für sämtliche Zeilen des Festkörperbildsensors (102), um eine Belichtung des Festkörperbildsensors (102) mittels einer Steuereinrichtung (107) zu beginnen,
- einen Schritt des Beendens einer Belichtung mit den Schritten
Schließen des mechanischen Verschlusses, nachdem eine vorbestimmte Belichtungszeitspanne verstrichen ist, um auf eine Lichtempfangsfläche des Festkörperbildsensors (102) einfallendes Licht zu blockieren, und
sequentielles Auslesen der Pixelsignale für jede Zeile des Festkörperbildsensors (102) bei geschlossenem mechanischem Verschluss,
- Empfangen einer Bildaufnahmeanfrage in Antwort auf einen Eingabevorgang durch einen Benutzer durch die Steuereinrichtung (107),
- Berechnen einer Belichtungszeitspanne auf der Grundlage eines vom Festkörperbildsensor (102) ausgegebenen Signals,
wobei,
falls die berechnete Belichtungszeitspanne geringer ist als oder gleich ist zu einem vorbestimmten Schwellwert, wenn eine Anfrage zur Aufnahme eines Standbildes empfangen wird, der Schritt des Beginnens der Belichtung und der Schritt des Beendens der Belichtung ausgeführt werden, und
ansonsten ein Schritt des sequentiellen Belichtens ausgeführt wird, wobei der Schritt des sequentiellen Belichtens das Ausführen eines Vorgangs des Rücksetzens der Pixelsignale, um die Belichtung der korrespondierenden Zeile im Festkörperbildsensor (102) zu beginnen, und eines
Vorgangs des Auslesens der Pixelsignale in Bezug auf die korrespondierende Zeile, nachdem die vorbestimmte Belichtungszeitspanne verstrichen ist, für jede Zeile aufweist.

6. Abbildungsverfahren nach Anspruch 5,
wobei in jedem Pixel im Festkörperbildsensors (102)
ein fotoelektrischer Wandler eine Signalladung korrespondierend zur Menge empfangenen Lichts erzeugt,
ein floatender Diffusionsbereich eine Menge der vom fotoelektrischen Wandler erzeugten Signalladung detektiert,
ein Übertragungstransistor (M12) die vom fotoelektrischen Wandler erzeugte Signalladung an den floatenden Diffusionsbereich überträgt und
ein Rücksetztransistor (M 15) die Spannung des floatenden Diffusionsbereichs auf ein vorbestimmtes Niveau zurücksetzt,
wobei beim Schritt des Beginnens der Belichtung die Steuereinrichtung (107) den Übertragungstransistor (M 12) und den Rücksetztransistor (M 15) einschaltet, um die im fotoelektrischen Wandler akkumulierte Signalladung und die Spannung des floatenden Diffusionsbereichs rückzusetzen, und
wobei beim Schritt des Beendens der Belichtung, nachdem der mechanische Verschluss geschlossen wurde, die Steuereinrichtung (107) die Spannungen aus dem floatenden Diffusionsbereich für jede Zeile ausliest, die zu der vom fotoelektrischen Wandler übertragenen Signalladung korrespondieren.

7. Abbildungsverfahren nach Anspruch 6,
wobei der Schritt des Beendens der Belichtung des Weiteren ein sequentielles Einschalten der Übertragungstransistoren (M 12) für jede Zeile, nachdem der mechanische Verschluss geschlossen wurde, um die Signalladung im fotoelektrischen Wandler an den floatenden Diffusionsbereich zu übertragen, und ein Auslesen der Spannung, die zu der übertragenen Signalladung korrespondiert, aus dem floatenden Diffusionsbereich, aufweist.

## Revendications

1. Appareil d'imagerie utilisant un capteur d'image à l'état solide (102) qui lit un signal de chaque pixel par un procédé d'adresse XY afin de capturer une image, l'appareil d'imagerie comprenant :
- un obturateur mécanique conçu pour bloquer la lumière incidente sur une surface de réception de lumière du capteur d'image à l'état solide (102) ;
- un moyen de commande (107) destiné à
réinitialiser simultanément les signaux de pixel pour toutes les rangées dans le capteur d'image à l'état solide (102) afin de démarrer l'exposition au capteur d'image à l'état solide (102),
fermer l'obturateur mécanique après l'écoulement d'une période d'exposition prédéfinie, et
lire séquentiellement les signaux de pixel pour chaque rangée du capteur d'image à l'état solide (102) lorsque l'obturateur mécanique est fermé, et
- un moyen de détection de période d'exposition destiné à calculer une période d'exposition sur la base d'un signal sorti du capteur d'image à l'état solide (102),
dans lequel, si la période d'exposition calculée est inférieure ou égale à une valeur seuil prédéfinie lorsqu'une demande de capture de l'image fixe est reçue, le moyen de commande commande l'opération de capture de l'image fixe par une première commande de fonctionnement d'obturateur, et
autrement, le moyen de commande commande l'opération de capture de l'image fixe par une seconde commande de fonctionnement d'obturateur,
dans lequel, dans la première commande de fonctionnement d'obturateur, les signaux de pixel sont simultanément réinitialisés pour toutes les rangées afin de démarrer l'exposition au capteur d'image à l'état solide (102), l'obturateur mécanique est fermé après l'écoulement de la période d'exposition prédéfinie et les signaux de pixel sont séquentiellement lus pour chaque rangée du capteur d'image à l'état solide (102) lorsque l'obturateur mécanique est fermé,
et dans lequel, dans la seconde commande de fonctionnement d'obturateur, une opération de réinitialisation des signaux de pixel pour démarrer l'exposition à la rangée correspondante dans le capteur d'image à l'état solide (102) et une opération de lecture des signaux de pixel pour la rangée correspondante après l'écoulement de la période d'exposition prédéfinie sont réalisées à chaque rangée.

2. Appareil d'imagerie selon la revendication 1, dans lequel chaque pixel dans le capteur d'image à l'état solide (102) comprend :
un transducteur photoélectrique conçu pour générer une charge de signal correspondant à la quantité de lumière reçue ;
une diffusion flottante conçue pour détecter une quantité de la charge de signal générée par le transducteur photoélectrique ;
un transistor de transfert (M12) conçu pour transférer la charge de signal générée par le transducteur photoélectrique à la diffusion flottante ; et
un transistor de réinitialisation (M15) conçu pour réinitialiser la tension de la diffusion flottante à un niveau prédéfini, et
dans lequel, lorsque l'exposition au capteur d'image à l'état solide (102) démarre, le moyen de commande (107) active le transistor de transfert (M12) et le transistor de réinitialisation (M15) pour réinitialiser la charge de signal accumulée dans le transducteur photoélectrique et la tension de la diffusion flottante.
et, après la fermeture de l'obturateur mécanique, le moyen de commande (107) lit séquentiellement les tensions correspondant à la charge de signal transférée depuis le transducteur photoélectrique à partir de la diffusion flottante pour chaque rangée.

3. Appareil d'imagerie selon la revendication 2,
dans lequel le moyen de commande (107) est conçu de manière à, après la fermeture de l'obturateur mécanique, activer en outre séquentiellement les transistors de transfert (M12) pour chaque rangée afin de transférer la charge de signal dans le transducteur photoélectrique vers la diffusion flottante et de lire la tension correspondant à la charge de signal transférée à partir de la diffusion flottante.

4. Appareil d'imagerie selon l'une quelconque des revendications 1 à 3,
dans lequel, pour réaliser la première commande de fonctionnement d'obturateur par le moyen de commande
l'obturateur mécanique comporte deux éléments de protection contre la lumière sectoriels (311, 312) ayant les mêmes axe central (301), forme et taille, et
l'obturateur mécanique est structuré de manière à bloquer sélectivement la lumière incidente sur le capteur d'image à l'état solide (102), la lumière traversant une position dans une zone que traversent les éléments de protection contre la lumière, en faisant se chevaucher les deux éléments de protection contre la lumière (311, 312) et en faisant tourner les éléments de protection contre la lumière (311, 312) autour de l'axe central (301) à la même vitesse prédéfinie dans des directions opposées.

5. Procédé d'imagerie pour utiliser un capteur d'image à l'état solide (102) qui lit un signal de chaque pixel par un procédé d'adresse XY afin de capturer une image, le procédé d'imagerie comprenant
- une étape de démarrage d'exposition comprenant
la réinitialisation simultanée des signaux de pixel pour toutes les rangées dans le capteur d'image à l'état solide (102) afin de démarrer l'exposition au capteur d'image à l'état solide (102) par un moyen de commande (107),
- une étape d'achèvement d'exposition comprenant les étapes consistant à
fermer l'obturateur mécanique après l'écoulement d'une période d'exposition prédéfinie afin de bloquer la lumière incidente sur une surface de réception de lumière du capteur d'image à l'état solide (102) et
lire séquentiellement les signaux de pixel pour toutes les rangées du capteur d'image à l'état solide (102) lorsque l'obturateur mécanique est fermé
- la réception d'une demande de capture d'image en réponse à une opération d'entrée par un utilisateur par le moyen de commande (107),
- le calcul d'une période d'exposition sur la base d'un signal sorti du capteur d'image à l'état solide (102),
dans lequel, si la période d'exposition calculée est inférieure ou égale à une valeur seuil prédéfinie lorsqu'une demande de capture de l'image fixe est reçue, réaliser l'étape de démarrage d'exposition et l'étape d'achèvement d'exposition, et
autrement, réaliser une étape d'exposition séquentielle,
dans lequel l'étape d'exposition séquentielle comprend la réalisation d'une opération de réinitialisation des signaux de pixel afin de démarrer l'exposition à la rangée correspondante dans le capteur d'image à l'état solide (102) et une opération de lecture des signaux de pixel pour la rangée correspondante après l'écoulement de la période d'exposition prédéfinie, à chaque rangée.

6. Procédé d'imagerie selon la revendication 5, dans lequel, dans chaque pixel dans le capteur d'image à l'état solide (102)
un transducteur photoélectrique génère une charge de signal correspondant à la quantité de lumière reçue ;
une diffusion flottante détecte une quantité de la charge de signal générée par le transducteur photoélectrique ;
un transistor de transfert (M12) transfère la charge de signal générée par le transducteur photoélectrique à la diffusion flottante ; et
un transistor de réinitialisation (M15) réinitialise la tension de la diffusion flottante à un niveau prédéfini,
dans lequel, à l'étape de démarrage d'exposition, le moyen de commande (107) active le transistor de transfert (M12) et le transistor de réinitialisation (M15) pour réinitialiser la charge de signal accumulée dans le transducteur photoélectrique et la tension de la diffusion flottante, et
dans lequel, à l'étape d'achèvement d'exposition, après la fermeture de l'obturateur mécanique, le moyen de commande (107) lit séquentiellement les tensions, correspondant à la charge de signal transférée depuis le transducteur photoélectrique, à partir de la diffusion flottante pour toutes les rangées.

7. Procédé d'imagerie selon la revendication 6, dans lequel l'étape d'achèvement d'exposition comprend en outre l'activation séquentielle des transistors de transfert (M12) pour toutes les rangées, après la fermeture de l'obturateur mécanique, afin de transférer la charge de signal dans le transducteur photoélectrique à la diffusion flottante et la lecture de la tension correspondant à la charge de signal transférée depuis la diffusion flottante.
